# EUROPEAN PATENT APPLICATION

(11) **EP 4 513 201 A1**
(43) Date of publication of application: **26.02.2025**
(21) Application number: 23192489.5
(22) Date of filing: 21.08.2023
(51) Int. Cl.: G01Q 70/16, G01Q 70/10, B81C 1/00

(54) **A METHOD FOR PRODUCING A SUBSTRATE COMPRISING SCANNING PROBE MICROSCOPY TIPS**

(71) Applicant: Imec VZW, 3001 Leuven (BE)
(72) Inventor: HANTSCHEL, Thomas, 2235 Houtvenne (BE); KIM, Hyeon-Su, 54653 Iksan (KR)
(74) Representative: Winger

(57) **Abstract**

A method of fabricating a substrate comprising on its surface one or more scanning probe microscopy tips, the method comprising:
A. Underetching beneath one or more hardmasks, each having rotational symmetry, present on a substrate, thereby forming a corresponding number of pre-tip structures having an upper part, a lower part, and a neck region linking the upper part to the lower part;
B. Then, etching the substrate underneath each pre-tip structure in a vertical manner using the respective hardmask as an etching mask, thereby forming a pedestal beneath the lower part of each pre-tip structure;
C. Then, selectively removing the hardmask from each structure;
D. Then, thinning down the neck until the upper part is physically detached from the lower part, thereby forming the substrate comprising on its surface the one or more scanning probe microscopy tips.

## Description

### Field of the Invention

The present invention relates to the field of scanning probe microscopy (SPM), and more in particular to the production of tips for SPM.

### State of the art.

In most setups for Scanning Probe Microscopy (SPM), an elongated strip probe moves relative to a sample. The probe has a holder at one end and a sharp tip at the other. This strip is known as the cantilever, while the tip, which is often pyramid- or cone-shaped, is fixed to the flat side of the cantilever. During an SPM data collection process, the tip either touches or comes very close to the sample's surface, while the probe follows a pre-determined route, commonly a series of parallel lines.

The interaction between the tip and the surface translates into information about the surface's physical properties, such as its topography, electrical or magnetic qualities, or even its composition, depending on the tip characteristics and the measurement setup. The probe can maintain continuous contact with the sample, or use an intermittent contact approach, where the surface features are assessed through changes in the impedance (electrical or other) of the link between the probe and the surface. A non-contact approach is also possible, dominated by non-contact forces like Vanderwaals forces.

One notable issue with contact-based SPM measurements is that the tip often wears out after numerous scans, necessitating its frequent replacement. Moreover, performing different types of SPM measurements on the same sample requires changing the probe type, which is a complex and time-consuming process. It involves not only the actual replacement of the probe but also refinding the area of interest on the sample.

To address these issues, a 'reverse setup' was developed, where the sample is affixed to a cantilever and scanned relative to a substrate embedded with several tips. This concept, hereinafter referred to as reverse-tip-sample scanning probe microscopy (RTS-SPM) is outlined in patent publication EP 3809143 B1. The current methods for creating such a 'tip substrate' are primarily derived from techniques used for cantilever-based tips. These involve making pyramid-shaped cavities in a silicon substrate, filling them with a tip material like diamond, and transferring these diamond tips to a carrier substrate. However, these methods are not capable of producing tips in large quantities as would be necessary for industrial-scale SPM applications, such as in a semiconductor production setting.

US patent application 2016/0068384 A1 presents a method of creating a substrate containing 480 silicon SPM tips per 100 cm² on its surface. Despite the innovation in this patent application, there is still a critical need for new methods that can facilitate the reliable formation of extremely sharp tips, preferably at a very high density on the substrate. This demand remains unmet, emphasizing the requirement for further advances in the production methods of tip substrates suitable for large-scale SPM applications.

### Summary of the invention

It is an object of the present invention to establish an efficient and reproducible method for fabricating a substrate comprising on its surface one or more scanning probe microscopy tips applicable in RTS-SPM.

In a first aspect, the present invention relates to a method of fabricating a substrate comprising on its surface one or more scanning probe microscopy tips, the method comprising:
a. underetching beneath one or more hardmasks, each having rotational symmetry, present on a substrate, thereby forming a corresponding number of pre-tip structures having an upper part, a lower part, and a neck region linking the upper part to the lower part;
b. then, etching the substrate underneath each pre-tip structure in a vertical manner using the respective hardmask as an etching mask, thereby forming a pedestal beneath the lower part of each pre-tip structure;
c. then, selectively removing the hardmask from each structure;
d. then, thinning down the neck until the upper part is physically detached from the lower part, thereby forming the substrate comprising on its surface the one or more scanning probe microscopy tips.

In a second aspect, the invention relates to the use of a substrate comprising on its surface a plurality of scanning probe microscopy tips obtainable by the method of any embodiment of the first aspect, for performing a scanning probe microscopy measurement, by attaching a sample to the end of a cantilever, and moving said sample relative to one or more of said scanning probe microscopy tips.

It is an advantage of the embodiments of the present invention that a highly efficient fabrication of tip-array structures suitable for RTS-SPM can be achieved.

A further advantage of the present invention is that it allows the creation of very sharp tips placed on a pedestal structure, achieving the ideal shape for a universal RTS-SPM tip.

It is also advantageous that the fabrication process utilizes a dry etching technique which addresses the problem of low reproducibility and sensitivity to parameter adjustments experienced with previous techniques.

Another advantage of embodiments of the present invention is that it permits wafer-scale fabrication with high process reproducibility and high tip uniformity, essential for commercial applications.

The invention's ability to execute the fabrication process using a single lithography step and a single etching step reduces the processing time and costs, making it another advantage of the present invention.

A significant advantage of the invention is its capability to use conventional and widely available lithography equipment, making the fabrication process suitable for standard cleanroom microfabrication facilities.

The ability of the invention to produce a vast number of high-performance RTS-SPM tips on a single wafer, such as about 50 million Si tips on a 300 mm Si wafer, is another advantageous aspect.

It is an advantage of embodiments of the present invention that it allows for the possibility of layer coating the fabricated Si tips with other materials, facilitating their use in different specialized modes of SPM measurement.

A further advantage of the invention is that it offers the potential for its method to be applied to many substrate materials, such as Si, SiGe, Ge, SiC, diamond, quartz, and glass, as well as layered substrate materials.

The advantage of the present invention that the process allows for highresolution measurements and tip switching in SPM, which improves the quality and statistical relevancy of the data, is also noteworthy.

These stated advantages underline the potential of the present invention to revolutionize the fabrication of tip-array structures for use in SPM, providing a more efficient, reliable, and versatile method compared to previous techniques.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change, and evolution of devices in this field, the present concepts are believed to represent substantial new and novel improvements, including departures from prior practices, resulting in the provision of more efficient, stable, and reliable devices of this nature.

The above and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the figures

FIG. 1 is a schematic illustration of a comparative fabrication process for an SPM tip as described in Scamporrino, G. (2021). Design, fabrication and evaluation of silicon tip chips for reverse tip sample scanning probe microscopy (Master's thesis). Politecnico di Torino.
FIG. 2A are SEM images of tips obtained by the fabrication process of FIG. 1. The tip and the pedestal are visible on the left side of the image and a zoom on the tip is shown on the right.
FIG. 2B was obtained by running an edge detection algorithm on FIG. 2A.
FIG. 3 is a schematic illustration of a fabrication process for an SPM tip according to an embodiment of the present invention.
FIG. 4A is an SEM image of an intermediate structure obtained after step c of the first aspect of the present invention.
FIG. 4B was obtained by running an edge detection algorithm on FIG. 4A.
FIG. 5A are SEM images showing from left to right: a tip obtained after step d, and improved version of that tip after a cleaning step e, a sharpening step f, and a further cleaning step g.
FIG. 5B was obtained by running an edge detection algorithm on FIG. 5A.
FIGs. 6A a), b), c), d), and e) are pictures of a prototype wafer fabricated according to the first aspect of the present invention. In the sequence a) to e), an increasing magnification is used.
FIG. 6B was obtained by running an edge detection algorithm on FIG. 6A.
FIG. 7A shows two tips obtained according to the first aspect of the present invention after a Pt coating (left) and a B-doped diamond coating (right).
FIG. 7B was obtained by running an edge detection algorithm on FIG. 7A.
FIG. 8A demonstrates on the left the use according to the second aspect of the present invention, and on the right the RTS-SPM images obtained through said use.
FIG. 8B was obtained by running an edge detection algorithm on FIG. 8A.

In the different figures, the same reference signs refer to the same or analogous elements.

### Detailed description of the invention

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and in the claims, are used for distinguishing between similar elements and not necessarily for describing a sequence, either temporally, spatially, in ranking, or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

The terms "over" and "above" are used as synonyms and cover situations with and without physical contacts. The term "on" means "over and in physical contact with".

It is to be noticed that the term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present (and can therefore always be replaced by "consisting of" in order to restrict the scope to said stated features) and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The initial RTS-SPM tip substrates at imec were fabricated using the molding technique. Inverted pyramids were etched into silicon (Si), these etch pits were then filled with diamond, and finally, the silicon substrate material was dissolved.

While these prototypes were instrumental in demonstrating the functionality and potential of RTS-SPM, they come with several drawbacks. Firstly, they possess a low aspect ratio, indicating a lack of ideal shape and structure for specific applications. Secondly, they lack sharpness, which can affect their precision. Moreover, their fabrication is restricted to a few select materials, such as diamond, silicon nitride, and certain metals. Finally, their fabrication process is quite intricate, involving numerous steps, which may not be ideal for large scale production.

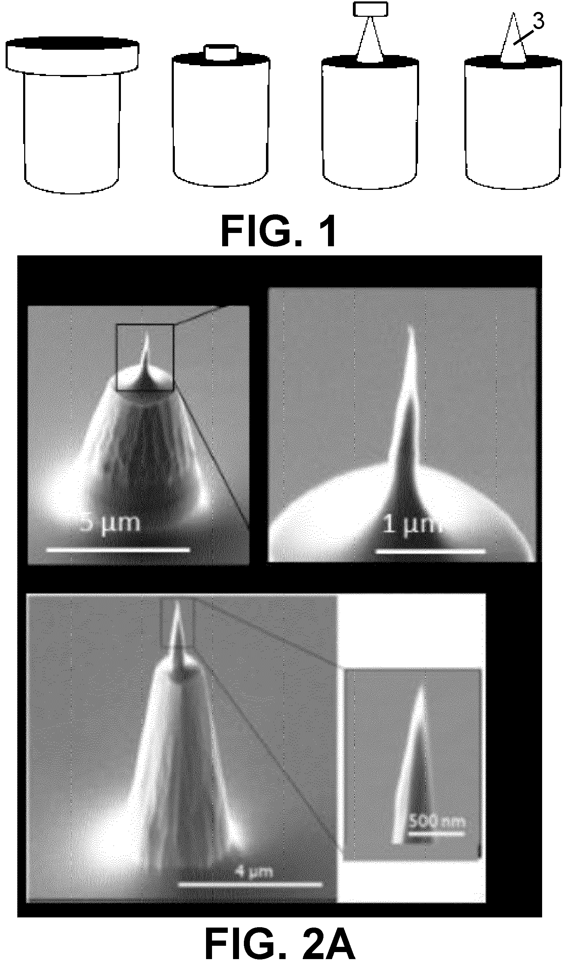

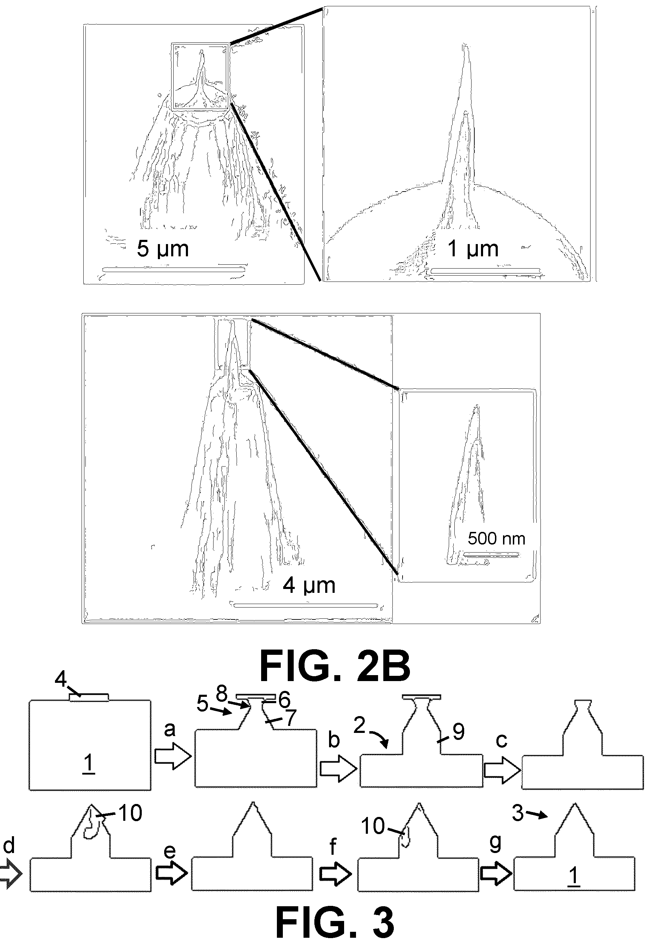

We now refer to FIG. 1. In a comparative example, tip (3) structures have been manufactured from silicon using a dry etching method, all in one lithography step. FIG. 1 offers a visual explanation of this process where from left to right the following steps are performed: a first etching step to create a pillar (first drawing), a mask reduction in oxygen plasma (second drawing), a second etching step to create the tip (3) (third drawing), and a resist removal step (last drawing). FIG. 2 presents a few examples of silicon tip (3) that were produced this way.

Unfortunately, although some suitable tip (3) array structures were created, this method lacks consistency. It's extremely sensitive to minute changes in the parameters. A notable problematic stage is the resist shrinkage phase, which proved to be unreliable, rendering this method unfit for massproduction of commercial tip-arrays.

We now refer to Fig. 3. The first aspect of the present invention relates to a method of fabricating a substrate (1) comprising on its surface (2) one or more scanning probe microscopy tip (3). The first aspect of the present invention represents a better technique to create these tip (3) or tip (3) arrays. It allows to create these on a large scale, with a high level of reproducibility and consistency in the tip (3). Furthermore, it is cost-effective and it can be accomplished using standard lithography with a single mask.

In embodiments, the method may be for fabricating a substrate (1) comprising on its surface (2) an array of at least 100, preferably at least 1000, more preferably at least 10000, even more preferably at least 500000 scanning probe microscopy tip (3). As we will see later on, this would require the method to underetch below a corresponding number of hardmasks (4) in step a.

When a plurality of tip (3) are formed by the method, they preferably form a regular 2-dimensional array. A regular array is an array with constant pitch in two orthogonal directions x and y. The pitch p may however be different in the x and y directions. Other distributions, including hexagonal or staggered distributions, as well as more random distributions of nano-sized tip (3) are also possible within the scope of the invention.

The distance between adjacent tip (3) may be chosen so as to enable the use of each tip (3) as an SPM tip (3) that is usable in a reverse-setup SPM measurement, by attaching a sample to a cantilever and moving the sample in contact with or in close vicinity to a tip (3). The large number of available tip (3) enables the performance of SPM acquisitions basically without requiring any physical/manual tip (3) replacements as would be the case in conventional SPM. In embodiments, the scanning probe microscopy tip (3) may be separated, in average, by 10 to 40 µm, e.g., by 15 to 35 µm, or by 20 to 30µm, e.g. by 25 µm.

In embodiments, the scanning probe microscopy tip (3) may have, as a number average, a height of from 5 to 15 µm.

In embodiments, the scanning probe microscopy tip (3) may have, as a number average, a width at mid-height of from 1 to 5 µm.

In embodiments, the scanning probe microscopy tip (3) may comprise an apex having a radius of curvature below 200 nm, preferably below 150 nm. For instance, the apex may be from 5 nm to 200 nm or from 80 nm to 150 nm.

The tip (3) are integral with the substrate (1), i.e. they are obtained by removing material from a substrate (1), typically having a planar upper surface (2), in areas around well-defined positions of the tip (3).

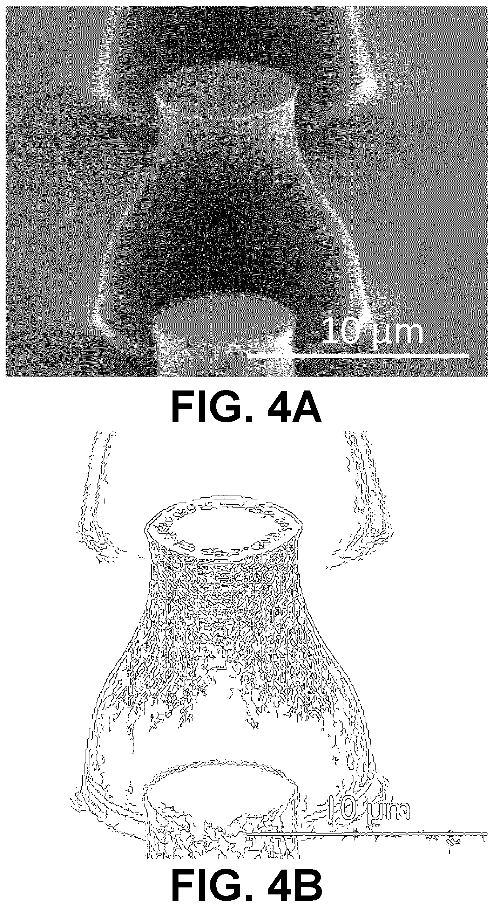

Referring to FIG.3, an embodiment according to the first aspect of the present invention is portrayed. The process is divided into mandatory steps a to d and optional steps e to g. Steps a to c involve defining a pedestal (9) with a tapered neck structure. The end result of this step in an exemplary embodiment where the substrate (1) is a silicon substrate (1) is shown in the SEM picture of FIG. 4.

In embodiments, the top surface (2) of the substrate (1) may comprise one or more layers selected from layers made of silicon, silicon-germanium, germanium, silicon carbide, diamond, quartz and glass.

Typically, the substrate (1) may comprise one or more layers selected from layers made of silicon, silicon-germanium, germanium, silicon carbide, diamond, quartz and glass. Preferably, the top layer of the substrate (1) or the only layer constituting the substrate (1) may be a layer selected from layers made of silicon, silicon-germanium, germanium, silicon carbide, diamond, quartz and glass.

Some examples of substrates (1) composed of multiple layers are a Si bottom wafer with an SiO2 top layer, a Si bottom wafer with a SiGe top layer, or a Si bottom wafer with a diamond top layer, etc.

For instance, the entire substrate (1) could be made of silicon, silicon-germanium, germanium, silicon carbide, diamond, quartz or glass. The most preferred substrate (1) is a silicon substrate (1), in particular a monocrystalline silicon substrate (1) such as a silicon wafer.

The top layer of the substrate (1), or if the substrate (1) is made of a single material, the substrate (1) preferably has a thickness of at least 20 µm.

Preferably, the top surface (2) of the substrate (1) comprising the tip (3) is globally flat.

Step a consists in underetching beneath one or more hardmasks (4), each having rotational symmetry, present on a substrate (1), thereby forming a corresponding number of pre-tip (5) structures having an upper part (6), a lower part (7), and a neck region (8) linking the upper part (6) to the lower part (7).

Step a is preferably a dry etching step. For instance, step a can be a step of isotropically underetching beneath the one or more hard mask.

In embodiments, it may be an inductively coupled plasma etching step. In embodiments, either the top surface (2) of the substrate (1) is made of silicon, silicon-germanium, germanium, silicon carbide, or glass and step ais an inductively coupled plasma etching step making use of halogen-containing etching gases, or the top surface (2) of the substrate (1) is made of diamond and step a is an inductively coupled plasma etching step making use of oxygen-containing gases.

In embodiments, either the top surface (2) of the substrate (1) is made of silicon, and step a is an inductively coupled plasma etching step alternating etching with SF6, CF4, or a mixture thereof with etching with C4F8. In embodiments, in step a the flow rate used for SF6, CF4, or the mixture thereof is larger than the flow rate used for C4F8.

Although the method of the present invention is suitable for forming a single tip (3), it is particularly advantageous when a plurality of tip (3) are formed on the substrate (1).

In embodiments, the method may be for fabricating a substrate (1) comprising on its surface (2) an array of at least 100, preferably at least 1000, more preferably at least 10000, even more preferably at least 500000 scanning probe microscopy tip (3), wherein the one or more hardmasks (4) are an array of at least 100, preferably at least 1000, more preferably at least 10000 hardmasks (4), even more preferably at least 500000 hardmasks (4).

The hardmask (4) can be any hardmask (4) but a photoresist is convenient.

Preferably, the hardmask (4) is circular but they could also be square, triangular, or in the shape of a regular polygon such as a pentagon, hexagon, heptagon, and so on, amongst others.

The base of the tip (3) typically have a shape corresponding to the shape of the hardmask (4) that has been used for their formation.

In embodiments, the density of hard masks may be at least one hardmask (4) per 10000 µm², preferably at least one hardmask (4) per 8000µm², more preferably at least one hardmask (4) per 6000 µm². Higher densities such as at least one hardmask (4) per 1000 µm², at least one hardmask (4) per 500 µm² can easily be achieved and permit the formation of a corresponding density of tip (3) and form embodiments of the present invention. However, for the purpose of use in a scanning probe microscopy measurement, and in particular for RTS-SPM, it is preferred if the density of hardmask (4) is from one hardmask (4) per 10000 µm² to one hardmask (4) per 2000 µm², preferably from one hardmask (4) per 8000 µm² to one hardmask (4) per 3000 µm², more preferably from one hardmask (4) per 5000 µm² to one hardmask (4) per 6000 µm². The use of such densities of hardmasks (4) lead to a corresponding density of tip (3).

For instance, step a forms a pre-tip (5) structure by isotropically underetching a circular photoresist hardmask (4), as shown in Fig. 3.

The pre-tip (5) structures have, below the hardmask (4), an upper part (6), a neck region (8), and a lower part (7). The neck region (8) is the thinner region of the pre-tip (5) structure. Typically, the maximum thickness of the upper part (6) is thinner than the maximum thickness of the lower part (7).

Then, step b is performed by etching the substrate (1) underneath each pre-tip (5) structure in a vertical manner using the respective hardmask (4) as an etching mask, thereby forming a pedestal (9) beneath the lower part (7) of each pre-tip (5) structure.

This step typically uses a more anisotropic etch to establish the pedestal (9).

Step b is preferably a dry etching step. For instance, step b can be a step of anisotropically etching the substrate (1) underneath each pre-tip (5) structure in a vertical manner using the respective hardmask (4) as an etching mask.

In embodiments, it may be an inductively coupled plasma etching step. In embodiments, either the top surface (2) of the substrate (1) is made of silicon, silicon-germanium, germanium, silicon carbide, or glass and step b is an inductively coupled plasma etching step making use of halogen-containing etching gases, or the top surface (2) of the substrate (1) is made of diamond and step b is an inductively coupled plasma etching step making use of oxygen-containing gases.

In embodiments, either the top surface (2) of the substrate (1) is made of silicon, and step b is an inductively coupled plasma etching step alternating etching with SF6, CF4, or a mixture thereof with etching with C4F8. In embodiments, in step b the flow rate used for SF6, CF4, or the mixture thereof may be lower than the flow rate used for C4F8.

In embodiments, step b can last, for instance, until a pedestal (9) of from 5 to 15 µm has been etched.

Then, step c is performed by selectively removing the hardmask (4) from each structure. By selectively, it is meant that the hardmask (4) is consumed at a slower rate than the tip (3) material, i.e., the than the material forming the top surface (2) of the substrate (1). Step c is preferably a dry etching step.

In embodiments, it may be an inductively coupled plasma etching step.

The result of step c can be seen in an exemplary embodiment in the SEM picture of FIG. 4.

Step d concerns the formation of the tip (3) from the tapered neck structure by thinning down the neck until the upper part (6) is physically detached from the lower part (7).

Step d is preferably a dry etching step. For instance, step d can be a step of isotropically underetching beneath the one or more hard mask.

In embodiments, it may be an inductively coupled plasma etching step. In embodiments, either the top surface (2) of the substrate (1) is made of silicon, silicon-germanium, germanium, silicon carbide, or glass and step d is an inductively coupled plasma etching step making use of halogen-containing etching gases, or the top surface (2) of the substrate (1) is made of diamond and step d is an inductively coupled plasma etching step making use of oxygen-containing gases.

In embodiments, either the top surface (2) of the substrate (1) is made of silicon, and step d is an inductively coupled plasma etching step alternating etching with SF6, CF4, or a mixture thereof with etching with C4F8. In embodiments, in step d the flow rate used for SF6, CF4, or the mixture thereof is larger than the flow rate used for C4F8.

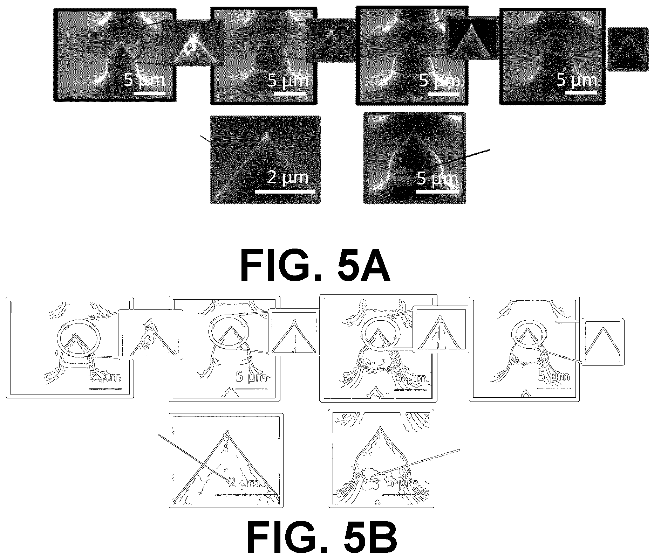

After this step, the tip (3) could already be used as such. However, it is not unusual that remnants of the separated neck piece remain close to the tip (3) apex. This is visible in the left SEM picture of Fig.5 as a small residue piece composed of a Silicon fragment and some polymer.

In embodiments, steps a, b, c, and d, as well as the one or more sharpening and/or cleaning steps if performed, may be dry etching steps.

In embodiments, the dry etching steps may be inductively coupled plasma etching steps.

In embodiments, either the top surface (2) of the substrate (1) is made of silicon, silicon-germanium, germanium, silicon carbide, or glass and steps a, b, and d are inductively coupled plasma etching steps making use of halogen-containing etching gases, or the top surface (2) of the substrate (1) is made of diamond and steps a, b, and d are inductively coupled plasma etching steps making use of oxygen-containing gases.

In embodiments, either the top surface (2) of the substrate (1) is made of silicon, and steps a, b, and d are inductively coupled plasma etching steps, each step alternating etching with SF6, CF4, or a mixture thereof with etching with C4F8.

In embodiments, in steps a and d the flow rate used for SF6, CF4, or the mixture thereof is larger than the flow rate used for C4F8 while in step b, the flow rate used for SF6, CF4, or the mixture thereof is lower than the flow rate used for C4F8.

In embodiments, the method may further comprise one or more sharpening and/or cleaning steps after step d, thereby forming the substrate (1) comprising on its surface (2) the one or more scanning probe microscopy tip (3). For instance, optional steps e to g depicted in Fig. 3 focus on the transformation of the tip (3) neck structure into a sharp tip (3) through a sequence of sharpening and cleaning operations.

In embodiments, the one or more sharpening and/or cleaning steps performed after step d may be a cleaning step e to remove residues (10) potentially present after step d on the one or more scanning probe microscopy tip (3), followed by a sharpening step f comprising removing material from the one or more scanning probe microscopy tip (3) cleaned in step e, followed by a further cleaning step g to remove residues (10) potentially present after step f on the one or more scanning probe microscopy tip (3).

The result of each step is shown for an exemplary embodiment in FIG. 5. These are SEM pictures of the tip (3) after step d (first picture from the left), after step e (second picture from the left, and magnified picture below it), after step f (third picture from the left and magnified picture below it), and after step g (fourth picture from the left).

In embodiments, the one or more cleaning steps are inductively coupled plasma etching steps making use of oxygen-containing gases.

In embodiments, the one or more sharpening steps (e.g., step f) are inductively coupled plasma etching steps making use of halogen-containing etching gases. Step f is preferably a dry etching step. For instance, step f can be a step of isotropically underetching beneath the one or more hard mask.

In embodiments, it may be an inductively coupled plasma etching step. In embodiments, either the top surface (2) of the substrate (1) is made of silicon, silicon-germanium, germanium, silicon carbide, or glass and step f is an inductively coupled plasma etching step making use of halogen-containing etching gases, or the top surface (2) of the substrate (1) is made of diamond and step f is an inductively coupled plasma etching step making use of oxygen-containing gases.

In embodiments, either the top surface (2) of the substrate (1) is made of silicon, and step f is an inductively coupled plasma etching step alternating etching with SF6, CF4, or a mixture thereof with etching with C4F8. In embodiments, in step f the flow rate used for SF6, CF4, or the mixture thereof is larger than the flow rate used for C4F8.

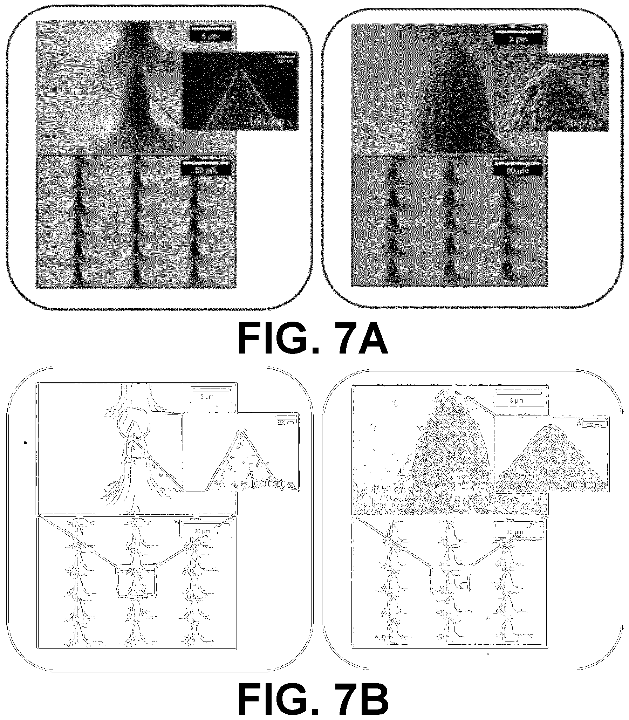

In embodiments, the method may further comprise, after the last of steps d, and the one or more sharpening and/or cleaning steps, applying a coating to the fabricated scanning probe microscopy tip (3), wherein said coating is one of diamond, doped diamond (e.g., B-doped diamond), a metal (e.g., Pt), a metal alloy (e.g., Pt-Ir), an oxide, or a nitride. FIG. 7 shows, on the left, Si tip (3) produced by an embodiment of the present invention on which Pt has been coated. On the right, Si tip (3) produced by an embodiment of the present invention on which B-doped diamond has been coated. An advantage of employing tip (3) produced by the first aspect, e.g., Si tip (3) produced thereby, for SPM measurements include the flexibility of modifying them for specific modes by applying an additional material layer coating to the tip (3). The process for covering such Si tip (3) with other materials, such as metals, oxides, or nitrides, is also straightforward.

Typically, a coating applied to the tip (3) is a few nanometres thick and can enhance various properties such as wear resistance, conductivity, magnetism, or chemical functionality. Hard metallic alloys such as TiN, diamond, and diamondlike carbon (DLC) may be used as coatings to bolster the wear resistance of the tip (3). The conductivity of the tip (3) can be improved with the use of metals or metallic alloys like Pt, Ptlr, Au, or Ni as coatings. Metallic or metallic alloy coatings such as Co or CoCr can imbue the tip (3) with magnetic properties.

Chemical functionalization, which is used for chemical force microscopy and single molecule detection applications, is achieved through the grafting of specific self-assembled monolayers (SAMs) with particular chemical functional groups on the tip (3). Silanization, etherification, hydrosilylation, or the immobilization of alkane thiols can be used to carry out such chemical modifications.

The principles of standard SPM technology, where the tip (3) is attached to a cantilever, determine the applicable thicknesses and materials of these coatings. The same parameters are relevant in the context of this invention.

Various methods like physical vapor deposition (PVD), atomic layer deposition (ALD), or chemical vapor deposition (CVD) can be employed to apply these functional coatings.

Preferably, the entire method is performed in the same etch tool.

It should be emphasized that the process developed herein facilitates the creation of high-performance tip-array structures, e.g., Si tip-array structures, in a cost-efficient way. This is achieved by employing only one lithography step (using a single mask) and preferably carrying out the multiple-step etching sequence in one go, using the same etch tool. The fabrication sequence (steps a-d) consists of just two main steps: one lithography step and one etching step, allowing the entire process to be completed in a short duration, with the total processing time for an Si array wafer being approximately 6-8 hours, or within a single working day.

The developed process employs micrometer-scale hardmask (4) patterning, making use of conventional and readily accessible lithography equipment, such as mask aligners, thereby eliminating the need for Deep Ultraviolet (DUV) or Extreme Ultraviolet (EUV) technology. The fabrication process can thus be carried out in a typical cleanroom microfabrication facility equipped with standard lithography tools and dry etching systems.

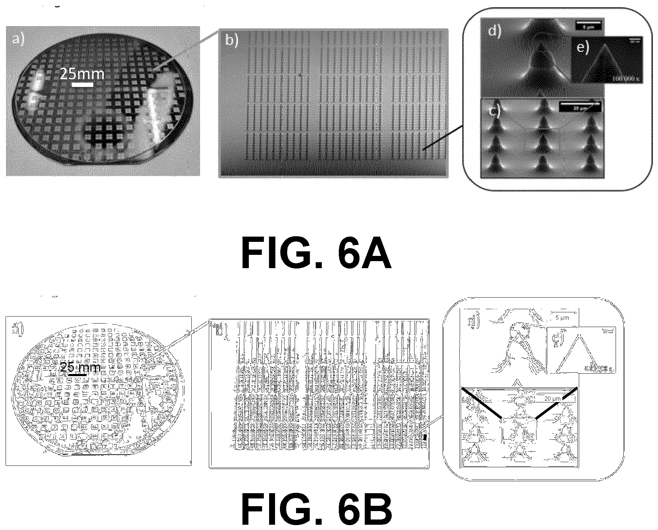

Initially, the etching process was developed and optimized on Si wafer pieces and was subsequently validated by etching Si tip-array structures on entire 100-mm diameter Si wafers. FIG. 6 displays an example of a Si tip (3) chip wafer fabricated in this manner. FIGs. 6 a), b), c), d), and e) are pictures of a prototype wafer fabricated according to the first aspect of the present invention. In the sequence a) to e), an increasing magnification is used. Experimental results have confirmed that Si array chips can be reproducibly fabricated using this developed approach.

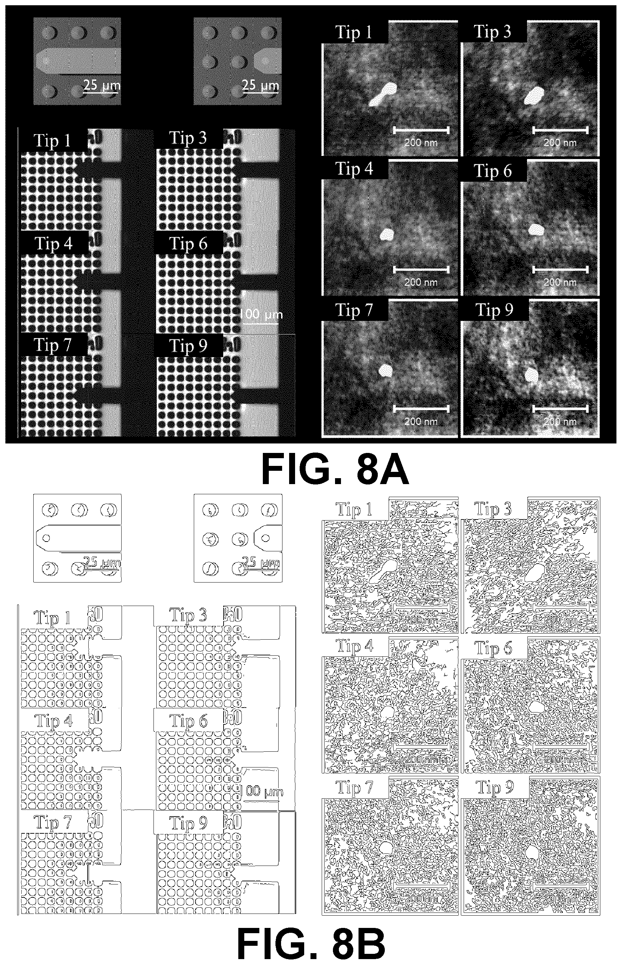

Fabricated Si tip (3) chip prototypes underwent extensive testing in SPM measurements. An illustration of this can be found in Fig. 8, where diamond nanoparticles fixed onto a Si cantilever were scanned through the technique of tip (3) switching. The fabricated prototype underwent evaluation in RTS-SPM tapping mode. This measurement entailed a scan involving the switching between 6 different Si tip (3) without physically disengaging the cantilever end from the Si tip (3) chip. It was observed that the same nanoparticle could be successfully relocated with each tip (3). It's important to note that tip (3) 1 and 3 presented a tip (3) artefact, which was readily identifiable because this artefact was absent in the scans from the other 4 tip (3). This experiment showcased not only the high resolution capabilities of the tip (3), but also the feasibility of switching tip (3) and then returning to the same area of interest. It should be noted that the ability to switch tip (3) comes with numerous advantages. The sharpest tip (3) can be selected for the final scan, and the statistical relevance of the measurement data can be enhanced. By using different tip (3) for scanning, the common problem of measurement artefacts in SPM can be detected and excluded.

Example of tip (3) fabrication procedure:

| **Mandatory** | **Step** | **Process** | **Parameters** |
|---|---|---|---|
| v | a | SF6 52.5sccm/C4F8 22.5sccm | RF 7W, ICP 200W, 15°C, 10mTorr, 30 min |
| v | b | SF6 35sccm/C4F8 45sccm | RF 7W, ICP 200W, 15°C, 10mTorr, 60 min |
| v | c | 02 50sccm/CF4 5sccm | RF 7W, ICP 200W, 20°C, 30mTorr, 12 min |
| v | d | SF6 52.5sccm/C4F8 22.5sccm | RF 7W, ICP 200W, 15°C, 10mTorr |
| x | e | 02 50sccm/CF4 5sccm | RF 5W, ICP 200W, 15°C, 30mTorr, 5 min |
| x | f | SF6 52.5sccm/C4F8 22.5sccm | RF 7W, ICP 200W, 15°C, 10mTorr |
| x | g | 02 50sccm/CF4 5sccm | RF 5W, ICP 200W, 15°C, 30mTorr, 15 min |

This table shows the sequence of process steps and parameters which were used to fabricate the tip (3) array prototypes. Note that the specified parameters represent the optimized values for the used Oxford Instruments ICP dry etching system, photoresist and mask design. Other dry etching tools, hardmasks (4) and mask designs might need other parameter values.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method of fabricating a substrate (1) comprising on its surface (2) one or more scanning probe microscopy tip (3), the method comprising:
a. underetching beneath one or more hardmasks (4), each having rotational symmetry, present on a substrate (1), thereby forming a corresponding number of pre-tip (5) structures having an upper part (6), a lower part (7), and a neck region (8) linking the upper part (6) to the lower part (7);
b. then, etching the substrate (1) underneath each pre-tip (5) structure in a vertical manner using the respective hardmask (4) as an etching mask, thereby forming a pedestal (9) beneath the lower part (7) of each pre-tip (5) structure;
c. then, selectively removing the hardmask (4) from each pre-tip structure;
d. then, thinning down the neck region (8) until the upper part (6) is physically detached from the lower part (7), thereby forming the substrate (1) comprising on its surface (2) the one or more scanning probe microscopy tip (3).

2. The method according to claim 1, further comprising one or more sharpening and/or cleaning steps after step d, thereby forming the substrate (1) comprising on its surface (2) the one or more scanning probe microscopy tip (3).

3. The method according to claim 2, wherein the one or more sharpening and/or cleaning steps performed after step d are a cleaning step e to remove residues (10) potentially present after step d on the one or more scanning probe microscopy tip (3), followed by a sharpening step f comprising removing material from the one or more scanning probe microscopy tip (3) cleaned in step e, followed by a further cleaning step g to remove residues (10) potentially present after step f on the one or more scanning probe microscopy tip (3).

4. The method according to any one of the preceding claims, wherein the method is executed in the same etch tool.

5. The method according to any one of the preceding claims, wherein the top surface (2) of the substrate (1) comprises one or more layers selected from layers made of silicon, silicon-germanium, germanium, silicon carbide, diamond, quartz and glass.

6. The method according to any one of the preceding claims, further comprising, after the last of steps d, and the one or more sharpening and/or cleaning steps, applying a coating to the fabricated scanning probe microscopy tip (3), wherein said coating is one of diamond, doped diamond, a metal, a metal alloy, an oxide, or a nitride.

7. The method according to any one of the preceding claims for fabricating a substrate (1) comprising on its surface (2) an array of at least 100, preferably at least 1.000, more preferably at least 10.000, even more preferably at least 500.000 scanning probe microscopy tip (3), wherein the one or more hardmasks (4) are an array of at least 100, preferably at least 1.000, more preferably at least 10.000 hardmasks (4), even more preferably at least 500.000 hardmasks (4).

8. The method according to any one of the preceding claims, wherein steps a, b, c, and d, as well as the one or more sharpening and/or cleaning steps if performed, are dry etching steps.

9. The method according to claim 8, wherein the dry etching steps are inductively coupled plasma etching steps.

10. The method according to claim 9, wherein either the top surface (2) of the substrate (1) is made of silicon, silicon-germanium, germanium, silicon carbide, or glass and steps a, b, and d are inductively coupled plasma etching steps making use of halogen-containing etching gases, or the top surface (2) of the substrate (1) is made of diamond and steps a, b, and d are inductively coupled plasma etching steps making use of oxygen-containing gases.

11. The method according to any one of the preceding claims, wherein either the top surface (2) of the substrate (1) is made of silicon, and steps a, b, and d are inductively coupled plasma etching steps, each step alternating etching with SF₆, CF₄, or a mixture thereof with etching with C₄F₈.

12. The method according to claim 11, wherein in steps a and d the flow rate used for SF₆, CF4, or the mixture thereof is larger than the flow rate used for C₄F₈ while in step b, the flow rate used for SF₆, CF4, or the mixture thereof is lower than the flow rate used for C₄F₈.

13. The method according to claim 2 or any claim depending thereon, wherein the one or more cleaning steps are inductively coupled plasma etching steps making use of oxygen-containing gases.

14. The method according to claim 2 or any claim depending thereon, wherein the one or more sharpening steps are inductively coupled plasma etching steps making use of halogen-containing etching gases.

15. Use of a substrate (1) comprising on its surface (2) a plurality of scanning probe microscopy tip (3) obtainable by the method of any one of the preceding claims, for performing a scanning probe microscopy measurement, by attaching a sample (10) to the end of a cantilever (12), and moving said sample relative to one or more of said scanning probe microscopy tip (3).
